# EUROPÄISCHE PATENTSCHRIFT

(11) **EP 0 802 266 B1**
(45) Veröffentlichungstag und Bekanntmachung des Hinweises auf die Patenterteilung: **02.08.2000**
(21) Anmeldenummer: 96106010.0
(22) Anmeldetag: 17.04.1996
(51) Int. Cl.: C23C 18/16, G06K 19/067

(54) **Verfahren zur Herstellung von induktiv arbeitenden Zählsystemen**
Process for manufacturing inductive payment systems
Procédé de fabrication de moyens de paiement inductifs

(43) Veröffentlichungstag der Anmeldung: 22.10.1997
(73) Patentinhaber: ATOTECH Deutschland GmbH, 10553 Berlin (DE)
(72) Erfinder: Kohnle Franz,Dipl-Ing, 12357 Berlin (DE); Dr.Meyer Heinrich,Dipl-Chem, 14109 Berlin (DE); Dr.Desmaison Gonzalo Urrutia,Dipl-Chem,, 10587 Berlin (DE)
(74) Vertreter: Kraus, Walter, Dr.

(56) Entgegenhaltungen:
- EP-A- 0 483 484

## Beschreibung

Die Erfindung betrifft ein Verfahren zur Herstellung von induktiv arbeitenden Zählsystemen, wie beispielsweise induktiv arbeitende Telefonkarten.

Die derzeit üblichen Telefonkarten können in zwei verschiedene Kategorien aufgeteilt werden. Die in Europa und den USA verwenden magnetische Schichten zur Informationsspeicherung. Das Kartentelefon besitzt dementsprechend eine Vorrichtung zum Lesen und zum Schreiben von Informationen auf der Karte. So werden gespeicherte Informationen, z.B. die noch vorhandenen Gebühreneinheiten, gelesen und in bestimmten Zeitabständen mit neuer Information überschrieben.

Bei einer weiteren Art von Telefonkarten, wie sie beispielsweise in Brasilien verwendet werden, wird ein anderes, wesentlich einfacheres Prinzip der Informationsspeicherung verwendet. Diese Telefonkarten bestehen aus einem Dielektrikum, auf dem eine dünne strukturierte Metallschicht aufgebracht wurde. Wesentliches Merkmal dieser Metallschicht ist ihre geometrische Form, die durch viele feine, leiterartige Stege gekennzeichnet ist. Die Funktion der Karte, die bei der Benutzung abläuft, besteht nun darin, daß das Kartentelefon sukzessive Induktionsströme in der Karte induziert, wodurch diese feinen Stege nacheinander durchgeschmolzen werden. Diese sehr feinen Stege funktionieren demnach wie eine Schmelzsicherung. Sind alle Stege durchgeschmolzen, ist die Karte entwertet. Solche Telefonkarten und die zugehörigen Telefone sind im Aufbau einfach, billig und robust, denn man benötigt keinen magnetischen Schreib- oder Lesekopf. Telefonkarten dieser Art werden nachstehend als induktiv arbeitende Telefonkarten bezeichnet. Natürlich kann dieses Prinzip auch als Zählsystem für andere Einheiten verwendet werden.

Nach der brasilianischen Patentanmeldung 9105585 A erfolgt ihre Herstellung durch ein Verfahren, bei dem zunächst auf ein impermeables, nicht poröses Substrat eine erste, leitende Schicht mit höherem Widerstand durch chemische Maßnahmen aufgebracht wird. Danach erfolgt eine elektrolytische Abscheidung einer wesentlich dickeren Schicht aus einem Metall oder einer Metallegierung mit erheblich geringerem Widerstand als derjenige der ersten Schicht. Die zweite Schicht besteht beispielsweise aus einer Zinn-Blei-Legierung, während die erste Schicht aus einer stromlos abgeschiedenen Nickelschicht besteht.

Bei dem derzeitigen Herstellungsverfahren wird von Kunststoffsubstraten, vorzugsweise aus Acrylnitril-Butadien-Styrol-Copolymeren (ABS), Polyvinylchloriden oder Epoxidharzen, ausgegangen. So werden beispielsweise zunächst zwei Folien aus den oben genannten Materialien mit den entsprechenden Abmessungen, z.B. 400 x 600 mm, miteinander verschweißt. Auf diese Weise entsteht ein sogenannter Mehrfach-Nutzen. Dann erfolgt eine Vorbehandlung durch Ätzen, Bürsten oder ähnliche Schritte zur Aufrauhung und/oder Hydrophilisierung der Nichtleiteroberfläche, um eine ausreichende Haftfestigkeit der anschließend außenstromlos aufzubringenden Metallschicht zu gewährleisten.

An diesen Verfahrensschritt schließt sich dann eine katalytische Aktivierung, beispielsweise die Belegung der Kunststoffoberfläche mit Palladiumkeimen, an. Darauf erfolgt eine ganzflächige chemisch reduktive Metallisierung, in der Praxis meistens eine außenstromlose Vernickelung. Diese Verfahrensschritte sind an sich von der Metallisierung von Kunststoffen her bekannt.

Danach erfolgt der Leiterbilderzeugungsprozeß der Metallschicht, insbesondere der feinen Metallstege. Dazu wird, ähnlich wie bei der Herstellung von Leiterplatten, eine photostrukturierbare Schicht, beispielsweise durch Lamination eines Photoresistfilms, aufgebracht. Dazu verwendet man sogenannte negativ arbeitende Trockenfilme, wie sie auch in der Leiterplattentechnik üblich sind. Das Belichten und das Leiterbild entwickeln erfolgt nach den üblichen Methoden, d.h. nach dem Entwickeln ist der Resist dort entfernt, wo später das Leiterbild entstehen soll. Schließlich wird die durch die außenstromlose Metallisierung aufgebrachte Metallschicht an den freiliegenden Stellen, d.h. im Resistkanal, galvanisch verstärkt, und zwar vorzugsweise mit einer Zinn-Bleilegierung. Zur Erzeugung des eigentlichen Leiterbildes wird zunächst der Photoresistfilm entfernt, in der Regel durch Behandeln mit wäßrig alkalischen Lösungen (Resiststripper). Anschließend muß die nun freigelegte stromlos abgeschiedene Metallschicht durch Ätzen entfernt werden. Die anschließende Beschichtung mit einem geeigneten Lack schützt die Karte, wobei der Schutzlack noch ein dekoratives Muster erhalten kann.

Üblicherweise werden dann die an den Rändern verschweißten Folien voneinander getrennt und die einzelnen Karten durch Stanzen oder Zerschneiden separiert.

Gewünschtenfalls kann die Karte in zwei Teile getrennt werden.

Die Nachteile des bestehenden Verfahrens, das sich stark an den für Leiterplatten üblichen sogenannten Substraktiv-Verfahren orientiert, bestehen erstens in der Schwierigkeit, die nur etwa 100 µm breiten Schmelzstege mit ausreichend hoher Präzision reproduzierbar zu ätzen. Die hohe Präzisionsanforderung ergibt sich aus der Funktion der Stege, die ja einen definierten elektrischen Widerstand besitzen müssen, der das Durchschmelzverhalten (W = I² x R) bestimmt. Die Praxis zeigt, daß durch die Probleme beim Ätzen der Stege das Risiko von Ausschuß beträchtlich ist.

Die Ursachen dafür liegen zum einen am Auflösungsvermögen des Trockenfilmresists und zum anderen an den technischen Grenzen des Leiterzugätzens.

Die EP-A-0 483 484 betrifft ein Verfahren zur Herstellung einer Leiterstruktur auf einem elektrisch nicht leitenden Substrat, welches die folgenden Verfahrensstufen umfaßt:
a) Aufbringen eines flüssigen Photoresists auf dem Substrat,
b) danach erfolgende Photostrukturierung der feinstrukturierten Anteile des Leiterbildes durch Belichten und anschließendes Entwickeln,
c) danach Aufbringen des für die stromlose Abscheidung von Metallen geeigneten Katalysators, und
d) danach erfolgendes stromloses Abscheiden einer dünnen Metallschicht auf den freiliegenden, katalytisch beschichteten Oberflächenbereichen.

Der Erfindung liegt die Aufgabe zugrunde, die oben beschriebenen Mängel des bekannten Verfahrens zu überwinden und ein wesentlich wirtschaftlicheres Verfahren zur Herstellung von Zählsystemen der oben beschriebenen zweiten Art bereitzustellen.

Diese Aufgabe wird erfindungsgemäß durch ein Verfahren zur lierstellung von induktiv arbeitenden Zählsystemen unter Erzeugung einer Leiterstruktur auf einem elektrisch nicht leitenden Substrat, umfassend eine Stufe des Aufbringens eines für die stromlose Abscheidung von Metallen geeigneten Katalysators auf das elektrisch nicht leitende Substrat sowie übliche Vorbehandlungs- und Nachbehandlungsschritte, gelöst, das durch die folgenden Verfahrensschritte gekennzeichnet ist:
1) Aufbringen eines flüssigen Photoresists, wobei der flüssige Photoresist nur auf die später vom Leiterbild nicht beanspruchte Fläche und auf die feinstrukturierten Anteile des Leiterbildes aufgedruckt wird,
2) danach erfolgende Photostrukturierung der feinstrukturierten Anteile des Leiterbildes durch Belichten und anschließendes Entwickeln,
3) danach erfolgendes stromloses Abscheiden einer ersten dünnen Metallschicht auf den freiliegenden, katalytisch beschichteten Oberflächenbereichen,
4) danach erfolgendes elektrolytisches Abscheiden einer zweiten Metallschicht auf der ersten Metallschicht und
5) danach erfolgendes Aufbringen einer dekorativen Schutzlackschicht,
wobei die Stufe des Aufbringens des für die stromlose Abscheidung von Metallen geeigneten Katalysators vor der Verfahrensstufe 3) durchgeführt wird und anschließend der Photoresist zusammen mit dem darauf adsorbierten Katalysator entfernt wird.

Eine bevorzugte Ausführungsform des erfindungsgemäßen Verfahrens ist dadurch gekennzeichnet, daß ein positiv arbeitender, siebdruckfähiger Photoresist verwendet wird.

Eine weitere bevorzugte Ausführungsform des erfindungsgemäßen Verfahrens ist dadurch gekennzeichnet, daß das Verfahren ohne Anwendung eines Ätzschritts durchgeführt wird.

Im Falle der Herstellung von induktiv arbeitenden Telefonkarten der oben beschriebenen Art werden erfindungsgemäß gegenüber dem bekannten Herstellungsverfahren effizient und vorteilhaft die Besonderheiten des Leiterbilds der Telefonkarte ausgenutzt:
1. Im Gegensatz zu Leiterplatten oder Halbleiterbausteinen, bei denen die Leiterzüge üblicherweise nur 5 bis 25% der Oberfläche beanspruchen, besteht bei den Telefonkarten der zweiten Art der weitaus größere Teil der Oberfläche aus Metall.
2. Ein weiteres Spezifikum der Telefonkarte besteht darin, daß es - anders als bei Leiterplatten - keine metallischen Inselstrukturen gibt. Das bedeutet, daß alle Elemente des gesamten Leiterbilds elektrisch leitend verbunden sind.

Aufbauend auf diesen beiden Merkmalen ermöglicht das erfindungsgemäße Herstellungsverfahren:
Erstens die vollständige Eliminierung des Leiterbildätzens und zweitens eine drastische Material- und Kosteneinsparung beim Photostrukturierungsprozeß. Anders als bei dem bekannten Verfahren, das sich an die Leiterplattenherstellung anlehnt, erfolgt im erfindungsgemäßen Verfahren die Photostrukturierung (d.h. die Beschichtung der Telefonkarte mit dem Photoresist, Belichtung und Entwicklung) schon nach der ganzflächigen Aktivierung. Der anschließende stromlose Metallisierungsprozeß erzeugt dann bereits das Leiterbild, da auf den mit Resist belegten Stellen naturgemäß kein Metall abgeschieden wird. Da es keine Inselstrukturen gibt, kann das mittels außenstromloser Metallisierung hergestellte Leiterbild problemlos mit elektrolytischen Metallisierungsverfahren galvanisch verstärkt werden.

Nach dem Entfernen des Photoresists ist das auf die erfindungsgemäße Weise erzeugte Leiterbild fertig, ohne daß geätzt werden muß. Die Vermeidung des Ätzschritts ist nicht nur eine Kostenersparung und Abwasservermeidung, sondern erhöht die Verfahrenssicherheit erheblich, weil die geometrische Definition der Stege erheblich verbessert wird.

Eine weitere erhebliche Kosteneinsparung bei nochmals verbesserter geometrischer Definition der Schmelzstege ergibt sich, wenn man anstelle eines negativ arbeitenden Trockenfilms, der ja vollflächig auflaminiert wird, im Siebdruckverfahren einen flüssigen Photoresist nur auf die später vom Leiterbild nicht beanspruchte Fläche und auf die fein strukturierten Anteile des Leiterbilds aufbringt, wobei mit dem flüssigen Photoresist, abhängig vom Leiterbild, nur ein kleiner Teil der Kartenfläche, bei den heutigen Telefonkarten nur 5 bis 10% der Kartenfläche, bedruckt werden. Der eigentliche Photoprozeß dient dann nur noch der Erzeugung der feinen, etwa 100 µm breiten Stege.

Die Vorzüge liegen auf der Hand:
Photoresistverbrauch, Entwicklungs- und Strippbäder werden um mehr als das Zehnfache gesenkt, weil der flüssige Resist nicht mehr vollflächig sondern nur auf den metallfreien Flächen in wesentlich dünnerer Schicht aufgetragen werden kann als der Trockenfilm, so daß eine Materialeinsparung von mehr als 50% durch die verminderte Schichtdicke hinzukommt.

Letztlich ergibt sich eine Materialeinsparung gegenüber dem konventionellen Trockenfilmprozeß um einen Faktor von 10 bis 20, der in speziellen Fällen sogar noch höher sein kann.

Gemäß einer bevorzugten Ausführungsform der Erfindung wird ein positiv arbeitender, flüssiger Photoresist verwendet. Damit ist der Vorteil einer geringeren Staubempfindlichkeit verbunden. Weiterhin wird in diesem Fall in der Regel ein erheblich verbessertes Auflösungsvermögen erzielt.

Durch das erfindungsgemäße Verfahren können Mittel zur irreversiblen Informationsspeicherung, insbesondere Automatenkarten zur elektronischen Abbuchung und vorzugsweise Telefonkarten der oben beschriebenen Art, hergestellt werden. Zum Speichern und Lesen der gespeicherten Informationen auf den Automatenkarten, beispielsweise Telefonkarten, werden die Metallstrukturen auf der Karte induktiv angesprochen. Beim Speicher-/Lesevorgang ist ein Satz Primärspulen mit einer Spule über jedem Feld der Metallstruktur angeordnet. Zum Speichern von Informationen wird durch eine Wechselspannung ein Magnetfeld in einzelnen Primärspulen und dadurch wiederum eine Wechselspannung in den einzelnen Feldern induziert. Sind einzelne Felder durch Brücken kurzgeschlossen, so steigt der Strom in den Primärspulen zum Erzeugen des Magnetfelds an. Ist keine Brücke vorhanden, so ist der Strom in den Primärspulen niedrig.

Zum Ändern der gespeicherten Informationen muß die jeweilige Brücke zerstört werden, so daß die Felder voneinander getrennt werden. Dazu wird lediglich die Wechselspannung in der Primärspule kurzzeitig erhöht.

Die Erfindung wird nachstehend anhand der Herstellung von Telefonkarten der oben genannten Art unter Bezugnahme auf die beigefügten Zeichnungen näher erläutert. Es zeigen:
Fig. 1 ein Substrat für eine Telefonkarte, wie es bei dem erfindungsgemäßen Verfahren eingesetzt wird,
Fig. 2 das nach dem erfindungsgemäßen Verfahren mit dem flüssigen Photoresist im Siebdruck bedruckte Substrat,
Fig. 3 einen Ausschnitt aus Fig. 2,
Fig. 4 das Produkt der vorletzten Stufe des erfindungsgemäßen Verfahrens und
Fig. 5 die fertige dekorativ beschichtete Telefonkarte, wie sie durch das erfindungsgemäße Verfahren erhalten wird.

Im folgenden werden die einzelnen Stufen des erfindungsgemäßen Verfahrens näher beschrieben. Grundsätzlich werden die nachstehend beschriebenen Schritte unter Anwendung der aus der Leiterplattentechnik bekannten Materialien und Verfahrensmaßnahmen durchgeführt, wie sie in der einschlägigen Literatur, beispielsweise dem "Handbuch der Leiterplattentechnik", 2. Auflage, 1982, Eugen G. Leuze Verlag, Saulgau, beschrieben werden.

### Vorbehandlung

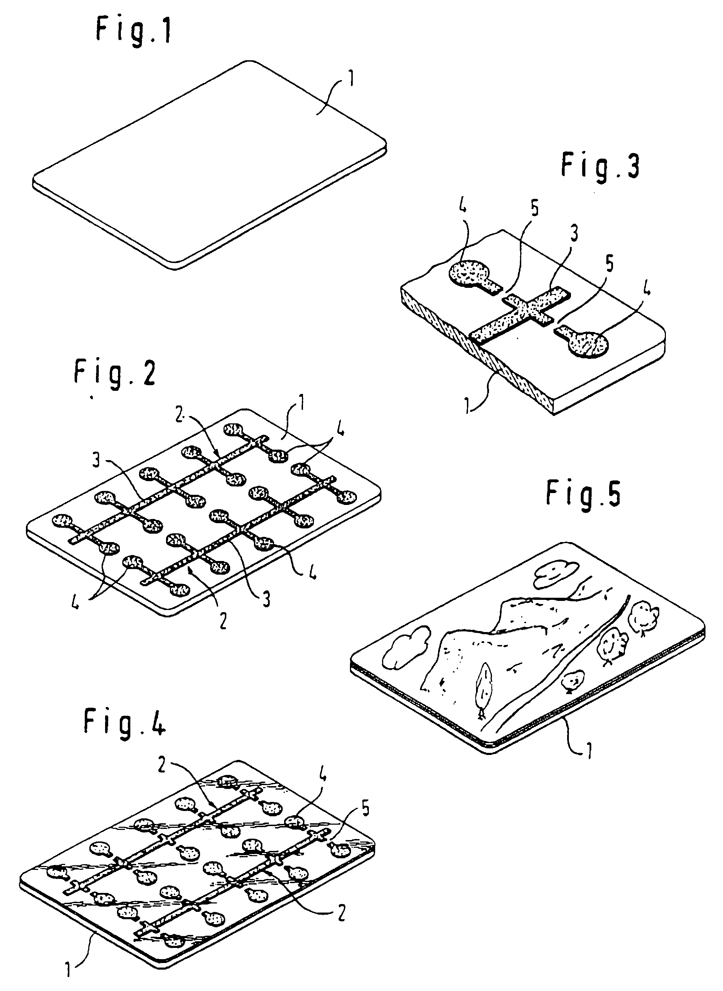

Wie bei den herkömmlichen Verfahren wird erfindungsgemäß von einem elektrisch nicht leitenden Kunststoffsubstrat, insbesondere einem solchen aus einem Acrylnitril-Butadien-Styrol-Copolymeren (ABS), Polyvinylchlorid oder Epoxidharze, ausgegangen. In Fig. 1 ist ein derartiges, 0,4 mm dickes Substrat gezeigt, das durch Verschweißen von zwei ABS-Folien mit den Abmessungen 400 x 600 mm erhalten wurde. Die Oberfläche des Substrats kann mit geeigneten Mitteln vorbehandelt werden, um eine ausreichende Haftfestigkeit zwischen den Metallstrukturen und der Oberfläche zu gewährleisten. Dies erfolgt meistens durch Reinigung und mechanische oder chemische Aufrauhung der Oberflächen. Dabei werden die Oberflächen in der Regel hydrophilisiert, d.h. mit Wasser benetzbar gemacht. Ferner können auch chemische funktionelle Gruppen in der Oberfläche durch gezielte chemische Reaktionen modifiziert werden. Als Reinigungslösungen werden im allgemeinen Netzmittel-enthaltende wäßrige Lösungen verwendet. Die Reinigungswirkung kann durch mechanische Bewegung der Behandlungslösung unterstützt werden. Besonders wirkungsvoll ist die zusätzliche Anwendung von Ultraschall. Zum chemischen Aufrauhen der Oberflächen können unterschiedliche Verfahren eingesetzt werden, die an die jeweiligen Materialien der Nichtleiter angepaßt sind. Für ABS-Polymere und Epoxidharze haben sich insbesondere chromsäurehaltige Lösungen, wie beispielsweise Chromschwefelsäure, als besonders geeignet erwiesen. Es ist auch möglich, alkalische Permanganatlösungen, diese in Verbindung mit organischen Quellösungen, konzentrierte Schwefelsäure und, im Falle von Polyamiden, alkalische Lösungen von organischen Lösungsmitteln einzusetzen.

### 1. Stufe

In dieser Stufe des erfindungsgemäßen Verfahrens wird durch ein Siebdruckverfahren die Grobstruktur des negativen Leitbildes mit einem flüssigen Photoresist aufgedruckt. Es ist ein wesentliches Merkmal des erfindungsgemäßen Verfahrens, daß in dieser Stufe der flüssige Photoresist in Siebdruck nur auf die später vom Leiterbild nicht beanspruchte Fläche und auf die feinstrukturierten Anteile des Leiterbildes aufgedruckt wird. Beispielsweise wird erfindungsgemäß nur 1 bis 10% der Substratoberfläche mit dem flüssigen Photoresist bedruckt.

Gemäß einer bevorzugten Ausführungsform der Erfindung wird ein positiv arbeitender, siebdruckfähiger Photoresist verwendet.

Anstelle eines flüssigen Photoresists kann auch ein geeigneter Lötstopp-Photolack verwendet werden.

Das wie oben beschrieben vorbehandelte und mit dem flüssigen Photoresist bedruckte Substrat ist in Fig. 2 dargestellt. Das Substrat wird durch das Bezugszeichen (1) angegeben, während der in baumähnlicher Form aufgedruckte flüssige Photoresist durch das Bezugszeichen (2) angegeben wird. Wie aus Fig. 2 ersichtlich, umfaßt der baumähnliche Aufdruck (2) stammartige Bereiche (3) und blattartige Bereiche (4).

Selbstverständlich lassen sich mit dem erfindungsgemäßen Verfahren auch andere Leiterbilder bzw. Schaltungsdesigns realisieren.

Der flüssige Photoresist ist hinsichtlich seiner rheologischen und thixotropen Eigenschaften in an sich bekannter Weise siebdruckfähig eingestellt worden. So kann beispielsweise die Viskosität durch Zugabe von geeigneten ThixotropierungsmitteIn, wie Organo-Bentoniten, Kaolinen, Alginsäuren, feinteiliger Kieselsäure oder ähnlichen Stoflen, die auch in den meisten Lötstopplacken enthalten sind, eingestellt werden. Viskosität und das thixotrope Verhalten entspricht den in der Leiterplattentechnik üblichen Siebdrucklacken.

### 2. Stufe

In dieser Stufe wird der aufgedruckte flüssige positive Photoresist durch eine Bildvorlage, vorzugsweise eine Schlitzmaske, so belichtet, daß beispielsweise ein Steg mit einer Breite von etwa 100 um gebildet wird. Es wird eine Schlitzmaske verwendet, die so ausgestaltet ist, daß nur der Bereich des "Asts" belichtet wird, der dem Steg entspricht. Durch die nur an der Stegstelle erfolgende Belichtung wird der Photoresist wasserlöslich gemacht und danach mit einem alkalischen Mittel, beispielsweise einer wäßrigen verdünnten Natriumcarbonatlösung, entwickelt. Der hierdurch erzeugte "Steg" ist in Fig. 3 durch das Bezugszeichen (5) angegeben.

Bei Verwendung eines negativen flüssigen Photolacks muß entsprechend eine Negativmaske verwendet werden.

### 3. Stufe

In dieser Stufe wird eine dünne erste Metallschicht stromlos ausschließlich auf den Bereichen abgeschieden, in denen die katalytisch aktive Schicht freigelegt wurde. Die Dicke richtet sich nach den Anforderungen der Telefonkarte und beträgt derzeit maximal 10 um. In den übrigen Bereichen wird kein Metall abgeschieden. Als stromlos abscheidbare Metalle kommen Nickel, Kupfer, Gold, Palladium und Kobalt in Betracht. Es werden solche Bäder bevorzugt, die nicht alkalisch sind, da in diesem Fall Photoresistmaterialien benutzt werden können, die in alkalischen Lösungen entwickel- und entfernbar sind.

Meist werden hierzu Bäder eingesetzt, aus denen das Metall durch Reduktion mittels in dem Bad enthaltener Reduktionsmittel abgeschieden wird. Beispielsweise kann Kupfer aus Formaldehyd-enthaltenden alkalischen, aber auch aus Hypophosphit-enthaltenden sauren oder neutralen Bädern abgeschieden werden. Auch Borhydrid-Verbindungen, beispielsweise Natriumborhydrid- und Dimethylaminoboran-enthaltende Kupferbäder, sind bekannt. Nickel und Kobalt sowie deren Legierungen werden vorzugsweise aus Hypophosphit-enthaltenden Lösungen abgeschieden. In diesem Fall entstehen Phosphorlegierungen. Mit Borhydrid-Verbindungen werden Borlegierungen der Metalle erhalten. Edelmetalle werden vorzugsweise aus Borhydrid-enthaltenden Bädern abgeschieden. Zur Abscheidung von Palladium sind auch Ameisensäure und Formiate-enthaltende Lösungen bekannt.

Eine andere Möglichkeit zur stromlosen Abscheidung der Metalle besteht darin, daß das Reduktionsmittel auf der zu beschichtenden Oberfläche adsorbiert ist und mit den Metallionen des stromlosen Bades reagiert. Beispielsweise können hierzu die in einem Palladium-Zinn-Katalysator enthaltenen Zinn(II)-Ionen, die an der Oberfläche als Zinn(II)-hydroxide vorliegen, verwendet werden. Diese Verfahrensweise wird in der EP 616 053 A1 beschrieben.

### 4. Stufe

Nach der Erzeugung der ersten, dünnen, leitfähigen Metallschicht wird diese durch weitere elektrolytische Metallisierung verstärkt. Die erforderliche Schichtdicke von 10 bis 50 µm wird durch elektrolytische Metallabscheidung erreicht. Diese erfolgt unter Anwendung üblicher galvanischer Bäder. Auch die Abscheidungsbedingungen entsprechen denjenigen der Leiterplattentechnik. Dadurch daß beim stromlosen Metallisieren auf den Resistoberflächen kein Metall niedergeschlagen worden ist, kann im elektrolytischen Bad an diesen Stellen auch kein Metall abgeschieden werden. Die Metallstrukturen werden schnell und mit guten metallphysikalischen Eigenschaften gebildet. Abscheidbare Metalle sind Kupfer, Nickel, Zinn, Blei, Gold, Silber, Palladium und andere Metalle sowie Legierungen dieser Metalle. Das in dieser Stufe erhaltene kartenförmige Produkt ist in Fig. 4 dargestellt.

### 5. Stufe

In dieser Stufe wird auf übliche Weise eine dekorative Schutzlackschicht aufgetragen. Die hierzu verwendeten Lacke und Verfahrensmaßnahmen sind mit denjenigen der Leiterplattentechnik identisch. Die fertige dekorativ beschichtete Karte ist in Fig. 5 gezeigt.

Das erfindungsgemäße Verfahren umfaßt weiterhin eine Stufe des Aufbringens eines für die stromlose Abscheidung von Metallen geeigneten Katalysators auf das elektrisch nicht leitende Substrat. Für die Aufbringung des Katalysators sind sowohl ionische als auch kolloidale Katalysatorsysteme bekannt. Meist wird Palladium als katalytisch aktives Metall verwendet. Kupfer eignet sich nur begrenzt, da es nur eine geringe katalytische Aktivität aufweist. Als ionische Katalysatoren werden beispielsweise Lösungen mit Komplexliganden komplexierten Palladiumionen verwendet. Die Erzeugung der katalytischen Aktivität erfolgt dann durch Reduktion der Palladiumverbindung zu Metall. Die kolloidalen Systeme enthalten Palladium in der Oxidationsstufe Null und als Schutzkolloid entweder eine organische Verbindung, wie beispielsweise Polyvinylalkohol, oder Zinn(ll)-hydroxide. Die letztgenannten Katalysatoren werden beispielsweise durch Zusammengeben von Palladiumchlorid und Zinn(II)-chlorid in salzsaurer Lösung und anschließendes Erwärmen gebildet. Zur Erzeugung der katalytischen Aktivität muß das Schutzkolloid entfernt werden. Dieser Verfahrensschritt wird in der Technik als Accelerieren bezeichnet.

Gemäß der Erfindung wird die Aufbringung des Katalysators vor der oben beschriebenen Verfahrensstufe 3), d.h. vor der stromlosen Abscheidung der ersten dünnen Metallschicht, durchgeführt.

Dabei umfaßt das erfindungsgemäße Verfahren auch eine Stufe, in der der Photoresist und der darauf adsorbierte Katalysator entfernt wird (Strip-off-Stufe). In dieser Stufe wird zweckmäßig, je nach Resisttyp, eine geeignete, in der Regel eine wäßrige alkalische Lösung oder eine Lösung organischer Lösungsmittel verwendet, wie sie aus der Leiterplattentechnik bekannt ist.

Die Stufe der Entfernung des Photoresists wird unmittelbar nach dem Aufbringen des für die stromlose Abscheidung von Metallen geeigneten Katalysators, d.h. vor der oben beschriebenen 3. Stufe, durchgeführt.

Naturgemäß können - ebenso wie in der Leiterplattentechnik - zwischen den einzelnen Prozeßstufen weitere Verfahrensschritte angewendet werden, wie beispielsweise Spülvorgänge, Reinigungs-, Konditionier-, Accelerierungs-, Beiz- und Ätzschritte sowie Erwärmungen des Substrats.

Die Erfindung wird in den Beispielen erläutert.

Die Bezugsbeispiele 1-3 sind nicht erfindungsgemäß.

### Bezugsbeispiel 1 (Permanent-Resist)

Ein plattenförmiges ABS-Substrat mit einer Dicke von 350 µm wurde durch Verschweißen von zwei ABS-Folien mit den Abmessungen 40 cm x 60 cm hergestellt. Zur Vorbehandlung wurde das so erhaltene ABS-Substrat in einer horizontal arbeitenden Bimsmehlbürstmaschine durch Aufsprühen und Aufbürsten eines Bimsmehl/Wasser-Gemisches aufgerauht und sodann getrocknet. Das so erhaltene ABS-Substrat wurde 5 Minuten lang in einem Chrom-Schwefelsäure-Beizaktivierungsbad (360 g/l Schwefelsäure und 360 g/l Chrom(VI)-oxid) gebeizt. Nach dem Spülen mit Wasser wurde das strukturierte und gebeizte ABS-Substrat mit einer Natriumbisulfitlösung (20 g/l) bei Raumtemperatur 1,5 Minuten lang chromreduziert. Nach erneutem Spülen wurde das Substrat 5 Minuten lang in eine wäßrige Lösung mit 250 mg/l Palladiumchlorid, 340 g/l Zinn(II)-chlorid und 250 g/l Natriumchlorid (Palladium-Kolloid mit Zinn(II)-hydroxid als Schutzkolloid) eingetaucht. Hierdurch wurden katalytisch wirksame Palladiumcluster auf der Oberfläche erzeugt. Überschüssige Behandlungslösung wurde danach durch Abspülen von der Oberfläche entfernt. Danach erfolgte 5 Minuten lang bei Raumtemperatur eine Accelerierungsbehandlung unter Verwendung eines bekannten Accelerators (Accelerator Aktivator AK2 der Firma Atotech). Nach dem Trocknen wurde mit einem Sieb (200 Mesh) das negative, grobe Leiterbild, d.h. ohne Berücksichtigung der Stege, gedruckt. Als Resist wurde eine entsprechend eingestellte, negativ arbeitende flüssige Lötstoppmaske VAQS der Firma Dupont verwendet. Unter Verwendung einer streifenförmigen Maske mit einer Breite von 100 µm, die die Stege abdeckte, wurde bei 365 nm belichtet, in üblicher Weise mit Natriumcarbonathaltiger Entwicklerlösung entwickelt und mehrfach mit heißem Wasser gespült. Das Aushärten des Lötstopplacks erfolgte durch gründliche UV-Bestrahlung. Für die Rückseite wurde der Photostrukturierungsprozeß wiederholt.

Anschließend wurde die nun freiliegende katalysierte Substratoberfläche durch Eintauchen in ein stromlos abscheidendes Nickelbad mit Hypophosphit als Reduktionsmittel bei 45°C innerhalb von 3 Minuten mit einer Nickel-Phosphor-Lierungsschicht belegt. Die Schichtdicke des stromlos aufgetragenen Nickels betrug 0,3 µm. Der pH-Wert des Nickelbades betrug etwa 7. Danach wurde überschüssiger Nickelelektrolyt abgespült. Anschließend wurde innerhalb von 12 Minuten eine Schicht einer Zinn-Blei-Legierung bei einer Stromdichte von 2 Å/dm² aus einem Methansulfonsäure-enthaltenden Zinn-Blei-Elektrolyten elektrolytisch abgeschieden. Die abgeschiedene Schichtdicke betrug 8 µm.

Danach wurde eine dekorative Schutzlackschicht üblicher Zusammensetzung aufgebracht.

### Bezugsbeispiel 2

Es wurde wie in Bezugsbeispiel 1, jedoch mit der Ausnahme verfahren, daß als Lötstopplack das Produkt ELPEMER^{R} der Firma Peters verwendet wurde.

### Bezugsbeispiel 3

Ein plattenförmiges ABS-Substrat mit einer Dicke von 350 um wurde durch Verschweißen von zwei ABS-Folien mit den Abmessungen 40 cm x 60 cm hergestellt. Zur Vorbehandlung wurde das so erhaltene ABS-Substrat in einer horizontal arbeitenden Bimsmehlbürstmaschine durch Aufsprühen und Aufbürsten eines Bimsmehl/Wasser-Gemisches aufgerauht. Sodann wurde 5 Minuten lang in einem Chrom-Schwefelsäure-Beizaktivierungsbad (360 g/l Schwefelsäure und 360 g/l Chrom(VI)-oxid) gebeizt und wie in Bezugsbeispiel 1 mit Palladium aktiviert. Nach dem Spülen mit Wasser von Raumtemperatur wurden noch anhaftende Reste von Chrom(VI)-Ionen durch 1,5minütiges Tauchen in 2 Gew.-%ige Natriumhydrogensulfitlösung reduziert. Nach erneutem Spülen mit Wasser wurde wie in Bezugsbeispiel 1 mit Palladium aktiviert.

Nach dem Trocknen wurde das negative, grobe Leiterbild in Analogie zu Bezugsbeispiel 1 aufgebracht, wobei die Maschenweite des Siebes jedoch 300 Mesh betrug. Es wurde ein positiv arbeitender Photolack (gemäß der deutschen Patentanmeldung P 195 46 140.1) verwendet.

Nach dem Trocknen des Photolacks wurde unter Verwendung einer 100 um breiten Schlitzmaske belichtet (200 mJ/cm²; 365 nm). Nach dem Belichten wurde die für diesen Resisttyp erforderliche thermische Nachbehandlung 20 Minuten lang bei 80°C durchgeführt, und anschließend wurde in 1%iger Sodalösung bei 30°C entwickelt. Anschließend wurde das Verfahren für die Rückseite der Platte wiederholt.

Sodann wurde die nun freiliegende katalysierte Substratoberfläche durch Eintauchen in ein stromlos abscheidendes Nickelbad mit Hypophosphit als Reduktionsmittel bei 45°C innerhalb von 3 Minuten mit einer Nickel-Phosphor-Legierungsschicht belegt. Die Schichtdicke des stromlos aufgetragenen Nickels betrug 0,3 um. Der pH-Wert des Nickelbades betrug etwa 7. Danach wurde überschüssiger Nickelelektrolyt abgespült. Anschließend wurde innerhalb von 12 Minuten eine Schicht einer Zinn-Blei-Legierung bei einer Stromdichte von 2 Å/dm² aus einem Methansulfonsäure-enthaltenden Zinn-Blei-Elektrolyten elektrolytisch abgeschieden. Die abgeschiedene Schichtdicke betrug 8 µm.

Danach wurde eine dekorative Schutzlackschicht üblicher Zusammensetzung aufgebracht.

Die so erhaltenen ABS-Plättchen wurden dann getrennt und zu den einzelnen Kartenformaten zugeschnitten. Bei der elektronischen Prüfung entsprachen die so hergestellten Karten den Anforderungen an brasilianische Telefonkarten.

### Beispiel 1

Ein plattenförmiges ABS-Substrat mit einer Dicke von 350 µm wurde durch Verschweißen von zwei ABS-Folien mit den Abmessungen 40 cm x 60 cm hergestellt. Zur Vorbehandlung wurde das so erhaltene ABS-Substrat in einer horizontal arbeitenden Bimsmehlbürstmaschine durch Aufsprühen und Aufbürsten eines Bimsmehl/Wasser-Gemisches aufgerauht und sodann getrocknet. Das so vorbehandelte Substrat wurde, wie in Bezugsbeispiel 3 beschrieben, mit einem positiv arbeitenden flüssigen Photolack selektiv bedruckt und die Stege photostrukturiert. Der Photostrukturierungsprozeß wurde dann für die Rückseite wiederholt.

Das so strukturierte ABS-Substrat wurde in einer Chrom-Schwefelsäurebeize bestehend aus 370 g/l Chromsäure und 370 g/l Schwefelsäure 3 Minuten bei 50°C gebeizt. Nach dem Spülen mit Wasser wurde das strukturierte und gebeizte ABS-Substrat mit einer Natriumbisulfitlösung (20 g/l) bei Raumtemperatur 1,5 Minuten lang chromreduziert. Nach erneutem Spülen wurde das Substrat 5 Minuten lang in eine wäßrige Lösung mit 250 mg/l Palladiumchlorid, 340 g/l Zinn(II)-chlorid und 250 g/l Natriumchlorid (Palladium-Kolloid mit Zinn(II)-hydroxid als Schutzkolloid) eingetaucht. Hierdurch wurden katalytisch wirksame Palladiumcluster auf der Oberfläche erzeugt. Überschüssige Behandlungslösung wurde danach durch Abspülen von der Oberfläche entfernt. Danach erfolgte 5 Minuten lang bei Raumtemperatur eine Accelerierungsbehandlung unter Verwendung eines handelsüblichen Accelerators (Accelerator Aktivator AK2 der Firma Atotech). Nach erneutem Spülen wurde das strukturierte und nunmehr accelerierte ABS-Substrat mit einer wäßrigen alkalischen Lösung mit 100 g/l Kaliumhydroxid behandelt, um den strukturierten Photoresist zu entfernen.

Anschließend wurde wiederum mit Wasser gespült, und sodann wurde die nun freiliegende katalysierte Substratoberfläche durch Eintauchen in ein stromlos abscheidendes Nickelbad mit Hypophosphit als Reduktionsmittel bei 45°C innerhalb von 3 Minuten mit einer Nickel-Phosphor-Legierungsschicht belegt. Die Schichtdicke des stromlos aufgetragenen Nikkels betrug 0,3 µm. Der pH-Wert des Nickelbades betrug etwa 7. Danach wurde überschüssiger Nickelelektrolyt abgespült. Anschließend wurde innerhalb von 12 Minuten eine Schicht einer Zinn-Blei-Legierung bei einer Stromdichte von 2 Å/dm² aus einem Methansulfonsäure-enthaltenden Zinn-Blei-Elektrolyten elektrolytisch abgeschieden. Die abgeschiedene Schichtdicke betrug 8 µm.

Danach wurde eine dekorative Schutzlackschicht üblicher Zusammensetzung aufgebracht.

## Patentansprüche

1. Verfahren zur Herstellung von induktiv arbeitenden Zählsystemen unter Erzeugung einer Leiterstruktur auf einem elektrisch nicht leitenden Substrat, umfassend eine Stufe des Aufbringens eines für die stromlose Abscheidung von Metallen geeigneten Katalysators auf das elektrisch nicht leitende Substrat sowie übliche Vorbehandlungs- und Nachbehandlungsschritte, gekennzeichnet durch die folgenden Verfahrensstufen:
1) Aufbringen eines flüssigen Photoresists, wobei der flüssige Photoresist nur auf die später vom Leiterbild nicht beanspruchte Fläche und auf die feinstrukturierten Anteile des Leiterbildes aufgedruckt wird,
2) danach erfolgende Photostrukturierung der feinstrukturierten Anteile des Leiterbildes durch Belichten und anschließendes Entwickeln,
3) danach erfolgendes stromloses Abscheiden einer ersten dünnen Metallschicht auf den freiliegenden, katalytisch beschichteten Oberflächenbereichen,
4) danach erfolgendes elektrolytisches Abscheiden einer zweiten Metallschicht auf der ersten Metallschicht und
5) danach erfolgendes Aufbringen einer dekorativen Schutzlackschicht,
wobei die Stufe des Aufbringens des für die stromlose Abscheidung von Metallen geeigneten Katalysators vor der Verfahrensstufe 3) durchgeführt wird und anschließend der Photoresist zusammen mit dem darauf adsorbierten Katalysator entfernt wird.

2. Verfahren nach Anspruch 1, dadurch gekennzeichnet, daß ein positiv arbeitender, siebdruckfähiger Photoresist verwendet wird.

3. Verfahren nach Anspruch 1 oder 2, dadurch gekennzeichnet, daß das Verfahren ohne Anwendung eines Ätzschritts durchgeführt wird.

4. Verfahren nach einem der Ansprüche 1 bis 3, dadurch gekennzeichnet, daß das induktiv arbeitende Zählsystem eine Telefonkarte ist.

## Claims

1. A process for producing inductively operating payment systems by generating a conductor structure on an electrically non-conducting substrate, comprising a step of application of a catalyst which is suitable for currentless deposition of metals onto the electrically non-conducting substrate as well as conventional steps for pre-treatment and post-treatment, characterised by the following process steps:
1) application of a liquid photoresist, said liquid photoresist being imprinted only onto the surface that is not loaded later by the conductive pattern and onto the finely-structured portions of the conductive pattern,
2) photostructuring, taking place thereafter, of the finely-structured portions of the conductive pattern by exposure and subsequent development,
3) currentless deposition, taking place thereafter, of a first thin metallic film on the bare, catalytically coated surface regions,
4) electrolytic deposition, taking place thereafter, of a second metallic film on the first metallic film and
5) application, taking place thereafter, of a decorative film of protective lacquer,
whereby the step of application of the catalyst which is suitable for currentless deposition of metals is carried out before process step 3) and the photoresist is subsequently removed together with the catalyst which is adsorbed on it.

2. Process according to Claim 1, characterised in that use is made of a photoresist which functions as a positive and which is screen-printable.

3. Process according to Claim 1 or 2, characterised in that the process is carried out without application of an etching step.

4. Process according to one of Claims 1 to 3, characterised in that the inductively operating payment system is a phonecard.

## Revendications

1. Procédé pour fabriquer des systèmes de paiement travaillant de façon inductive, moyennant la réalisation d'une structure conductrice sur un substrat non électriquement conducteur, comprenant une étape d'application d'un catalyseur convenant pour le dépôt autocatalytique de métaux, sur le substrat non électriquement conducteur, ainsi que d'autres étapes de prétraitement et de post-traitement, caractérisé par les étapes opératoires suivantes:
1) dépôt d'un photoresist liquide, le photoresist liquide étant appliqué par impression sur la surface, qui n'est pas utilisée ultérieurement par la configuration de conducteurs et sur les parties finement structurées de la configuration de conducteurs,
2) structuration photochimique, exécutée ensuite, des parties finement structurées de la configuration de conducteurs par exposition et développement ultérieur,
3) dépôt autocatalytique, effectué ensuite, d'une première couche métallique mince sur les parties libres de la surface, recouvertes de façon catalytique,
4) dépôt électrolytique, exécuté ensuite, d'une seconde couche métallique sur la première couche métallique, et
5) dépôt, effectué ensuite, d'une couche décorative de laque protectrice,
l'étape d'application du catalyseur convenant pour le dépôt autocatalytique de métaux étant exécutée avant l'étape opératoire 3) et le photoresist étant ensuite éliminé conjointement avec le catalyseur adsorbé sur le photoresist.

2. Procédé selon la revendication 1, caractérisé en ce qu'on utilise un photoresist à action positive, convenant pour la sérigraphie.

3. Procédé selon la revendication 1 ou 2, caractérisé en ce qu'on met en oeuvre le procédé sans l'utilisation d'une étape d'attaque chimique.

4. Procédé selon l'une des revendications 1 à 3, caractérisé en ce que le système de paiement, qui travaille de façon inductive, est une carte téléphonique.
